# EUROPEAN PATENT APPLICATION

(11) **EP 3 506 505 A1**
(43) Date of publication of application: **03.07.2019**
(21) Application number: 18213756.2
(22) Date of filing: 18.12.2018
(51) Int. Cl.: H03K 17/081, H02M 1/32, H02M 1/088

(54) **DETECTION DEVICE, PROTECTION SYSTEM AND METHOD FOR SERIES CONNECTED SWITCH DEVICES**

(30) Priority: 02.01.2018 CN 201810001543
(71) Applicant: General Electric Company, Schenectady, NY 12345 (US)
(72) Inventor: Mechlinski, Marius, 85748 Bavaria (DE); Zhihui, Yuan, 85748 Bavaria (DE); Shi, Jingkui, ShangHai, Shanghai 201203 (CN); SCHROEDER, Stefan, 85748 Bavaria (DE)
(74) Representative: Rüger Abel

(57) **Abstract**

A detection device (820) for a circuit comprising a plurality of switch devices (910) coupled in series. The detection device (820) comprises a plurality of detecting circuits (821), wherein each detecting circuit is integrated with a gate driver (810) of a corresponding switch device. Each detecting circuit comprises a voltage divider (140) and a signal processor (130). The voltage divider is coupled in parallel with the corresponding switch device. The signal processor is coupled with a voltage dividing component (120) of the voltage divider and configured to output an output signal (133) indicating the voltage across the switch device. Embodiments also relate to a system and method for protecting series-connected switch devices.

## Description

### BACKGROUND

Embodiments of the present disclosure relate generally to detecting devices, protection systems and protection methods.

Series-connected switch devices are widely used in power converters. The switch devices often encounter over-voltage events at various working scenarios, which will damage the switch device and thus the series branch in a very short time. Therefore, fast detection of over-voltage is a key issue to prevent the switch device from failure.

In conventional methods, the detection of over-voltage is usually not fast enough to allow further actions, such as turning-on the switch device, to be taken before the failure.

Therefore, it is desirable to provide new detection devices, protection systems and protection methods for switch devices coupled in series to solve the above-mentioned problem.

### BRIEF DESCRIPTION

In one aspect, embodiments of the present disclosure relate to a detection device for a circuit comprising a plurality of switch devices coupled in series. The detection device comprises a plurality of detecting circuits , wherein each detecting circuit is integrated with a gate driver of a corresponding switch device. Each detecting circuit comprises a voltage divider and a signal processor. The voltage divider is coupled in parallel with the corresponding switch device and comprises a plurality of voltage dividing components coupled in series. The signal processor is coupled with one of the voltage dividing components and configured to receive a divided voltage across the voltage dividing component and output an output signal indicating the voltage across the switch device.

In another aspect, embodiments of the present disclosure relate to a system for protecting a circuit comprising a plurality of switch devices coupled in series. The system comprises a detection device comprising a plurality of detecting circuits , wherein each detecting circuit is integrated with a gate driver of a corresponding switch device. Each detecting circuit comprises a voltage divider and a signal processor. The voltage divider is coupled in parallel with the corresponding switch device and comprises a plurality of voltage dividing components coupled in series. The signal processor is coupled with one of the voltage dividing components, and configured to receive a divided voltage across the voltage dividing component and output an output signal indicating the voltage across the switch device. The system further comprises a control device configured to determine whether each switch device has a failure risk based on the output signal, and make the switch device(s) having the failure risk in a constant on-state to reduce the failure risk.

In another aspect, embodiments of the present disclosure relate to a method for protecting a circuit comprising a plurality of switch devices coupled in series. The method comprises detecting a voltage across each switch device by a detecting device; determining whether each switch device has a failure risk based on the voltage; and making each of the switch device(s) having the failure risk in a constant on-state to reduce the failure risk. The detecting device comprises a plurality of detecting circuits, wherein each detecting circuit is integrated with a gate driver of a corresponding switch device. Each detecting circuit comprises a voltage divider and a signal processor. The voltage divider is coupled in parallel with the corresponding switch device and comprises a plurality of voltage dividing components coupled in series. The signal processor is coupled with one of the voltage dividing components, and configured to receive a divided voltage across the voltage dividing component and output an output signal indicating the voltage across the switch device.

### DRAWINGS

These and other features, aspects, and advantages of the present disclosure will become better understood when the following detailed description is read with reference to the accompanying drawings in which like characters represent like parts throughout the drawings, wherein:
Fig. 1 is a sketch view of a circuit protection system in accordance with an exemplary embodiment of the present disclosure.
Fig. 2 is a perspective view of a printed circuit board comprising a detecting circuit and a gate driver in accordance with an exemplary embodiment of the present disclosure;
Fig. 3 is a front view of the printed circuit board shown in Fig. 2;
Fig. 4 is a sketch view of a detecting circuit in accordance with an exemplary embodiment of the present disclosure;
Fig. 5 is a sketch view of a detecting circuit in accordance with another exemplary embodiment of the present disclosure;
Fig. 6 is a sketch view of a detecting circuit in accordance with another exemplary embodiment of the present disclosure;
Fig. 7 is a sketch view of a detecting circuit in accordance with another exemplary embodiment of the present disclosure; and
Fig. 8 is a flowchart illustrating a method for protecting a circuit comprising a plurality of switch devices coupled in series in accordance with an exemplary embodiment of the present disclosure.

### DETAILED DESCRIPTION

In an effort to provide a concise description of these embodiments, not all features of an actual implementation are described in one or more specific embodiments. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of the present disclosure.

Unless defined otherwise, technical and scientific terms used herein have the same meaning as is commonly understood by one of ordinary skill in the art to which the present disclosure belongs. The terms "first," "second," "third," "fourth," and the like, as used herein do not denote any order, quantity, or importance, but rather are used to distinguish one element from another. Also, the terms "a" and "an" do not denote a limitation of quantity, but rather denote the presence of at least one of the referenced items. The term "or" is meant to be inclusive and mean either any, several, or all of the listed items. The use of "including," "comprising," or "having," and variations thereof herein are meant to encompass the items listed thereafter and equivalents thereof as well as additional items.

Embodiments of the present disclosure relate to a protection system for series-connected switch devices. The protection system comprises a detection device, which can be used to detect a voltage across each switch devices quickly and precisely.

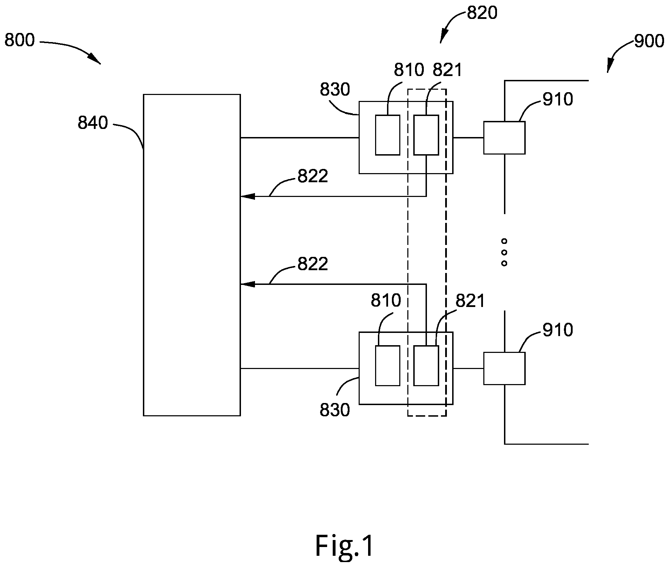

Fig. 1 shows a protection system 800 configured to protect a circuit 900, wherein the circuit 900 comprises a plurality of switch devices 910 coupled in series. In some embodiments, the switch device 910 comprises at least one of a silicon carbide insulated gate bipolar transistor (IGBT) and a silicon carbide metal-oxide-semiconductor field effect transistor (MOSFET). Referring to Fig. 1, the protection system 800 comprises a plurality of gate drivers 810, a detection device 820 and a control device 840.

The plurality of gate drivers 810 are coupled to the plurality of switch devices 910 respectively. Each gate driver 810 is configured to provide a gate signal to a corresponding switch device 910 under control of the control device 840, so as to switch on or off the switch device 910 according to practical needs. In a normal working condition of the switch device 910, the switch device 910 may be switched on and off repetitively. In an abnormal condition of the switch device 910, the switch device 910 may be made in a constant on-state or a constant off-state.

The detection device 820 comprises a plurality of detecting circuits 821 configured to detect voltage information associated with the plurality of switch devices 910 respectively. Each detecting circuit 821 is configured to detect a voltage across the corresponding switch device and output an output signal 822 to the control device 840, wherein the output signal 822 indicates the voltage across the switch device. The output signal may indicate a value of the voltage or whether the voltage exceeds a normal operating voltage of the switch device.

The control device 840 is configured to receive the output signal 822 from the detecting circuit 821 and determine whether each switch device 910 has a failure risk based on the output signal 822. In some embodiments, if a switch device is determined to have a failure risk, the control device 840 makes the switch device in a constant on-state, in order to reduce or eliminate the failure risk. The control device 840 may control the gate driver 810 to provide a constant-on signal to the switch device 910. As such, the switch device in the constant on-state acts as a wire in the series branch without overvoltage issue. Since the overvoltage is a main cause leading to the failure of a switch device, making the switch device in the constant on-state can prevent the failure of the switch device. Meanwhile, the other switch devices in the series branch can keep working as normal.

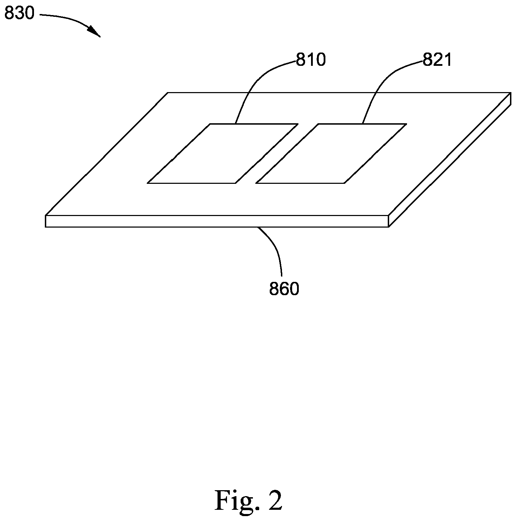

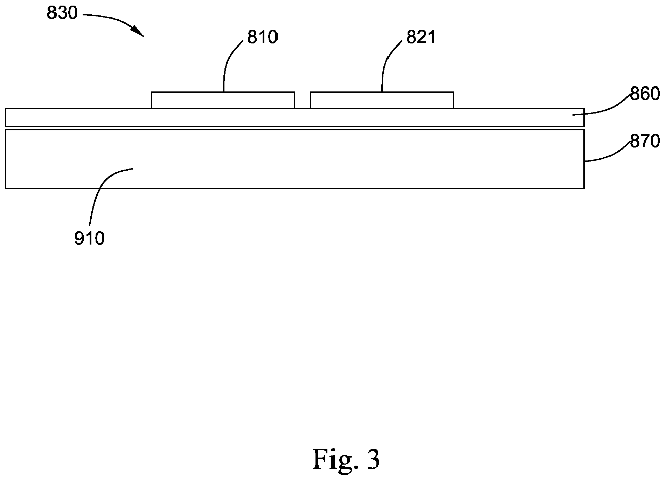

Each detecting circuit 821 is integrated with the gate driver 810 of the corresponding switch device 910. Referring to Fig. 2 and Fig. 3, the detecting circuit 821 and the gate driver 810 are provided on a substrate 860 to form a printed circuit board 830. At least a part of the detecting circuit, for example, wires of the detecting circuit, may be printed on the substrate 860, and components of the detecting circuit 821 may be mounted on a surface of the substrate 860. The printed circuit board 830 is adjacent to the corresponding switch device 910, in such a manner that the detecting circuit 821 is close to the corresponding switch device 910, which will reduce a response time of the detecting circuit. Therefore, the detecting device in the present disclosure can achieve a fast measurement or detection of over-voltage events or risks of failure, so that the control device 840 will have plenty of time to take further actions to prevent the switch device from failure.

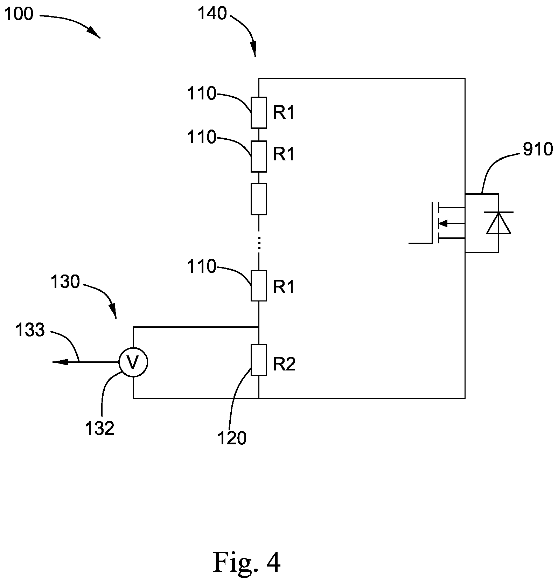

Fig. 4 shows a sketch view of a detecting circuit 100 in accordance with an exemplary embodiment of the present disclosure. Referring to Fig. 4, the detecting circuit 100 comprises a voltage divider 140 and a signal processor 130.

The voltage divider 140 is coupled between the switch device 910 and the signal processor 130, and configured to receive a voltage across the switch device and output a divided voltage to the signal processor 130. The voltage divider 140 is coupled in parallel with the corresponding switch device 910 and comprises a plurality of voltage dividing components 110, 120 coupled in series.

The plurality of voltage dividing components comprises a plurality of first voltage dividing components 110 and a second voltage dividing component 120. The plurality of first voltage dividing components 110 are in series connection, and the second voltage dividing component 120 is coupled with the signal processor 130 and configured to provide a divided voltage to the signal processor 130. In the embodiment shown in Fig. 4, each voltage dividing component comprises a resistor. A first resistor R1 of the first voltage dividing component 110 has a resistance larger than a second resistor R2 of the second voltage dividing component 120, in such a manner that more voltage will be distributed to the first voltage dividing components, and thus the divided voltage across the second voltage dividing component 120 can be reduced and so as to more easily be measured or processed. The first and second resistors may also have parasitic capacitance engaging in the voltage dividing.

The signal processor 130 is coupled with the second voltage dividing component 120, and configured to receive the divided voltage across the second voltage dividing component 120 and output an output signal 133, wherein the output signal 133 indicates the voltage across the switch device 910. In the embodiment shown in Fig. 4, the signal processor 130 comprises a measuring device 132 which is configured to measure the divided voltage and output a voltage value 133.

In the above embodiment, the signal processor 130 receives the divided voltage across one voltage dividing component 120. However, in some other embodiments, the signal processor may receive the divided voltage across two or more voltage dividing components.

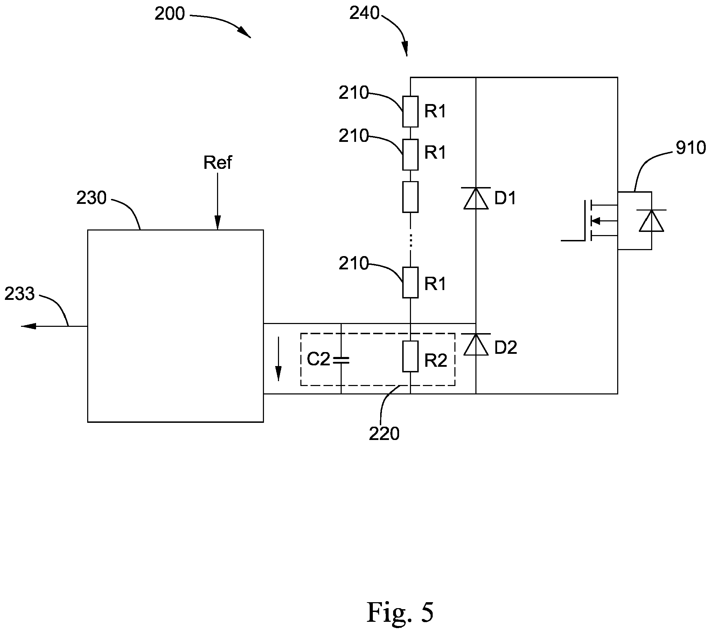

Fig. 5 shows a sketch view of a detecting circuit 200 in accordance with another exemplary embodiment of the present disclosure. Referring to Fig. 5, the detecting circuit 200 comprises a voltage divider 240, a signal processor 230, a first diode D1 and a second diode D2.

The voltage divider 240 is coupled in parallel with the corresponding switch device 910 and comprises a plurality of voltage dividing components 210, 220 coupled in series. The plurality of voltage dividing components comprises a plurality of first voltage dividing components 210 and a second voltage dividing component 220. The plurality of first voltage dividing components 210 are in series connection. The second voltage dividing component 220 is coupled with the signal processor 230 and configured to provide a divided voltage to the signal processor 230.

In the embodiment shown in Fig. 5, each of the first voltage dividing component 210 comprises a first resistor R1. The second voltage dividing component 220 comprises a second resistor R2 and a capacitor C2 coupled in parallel with the second resistor R2. The first resistor R1 has a resistance larger than the second resistor R2, in such a manner that more voltage will be distributed to the first voltage dividing components. Thus, the divided voltage across the second voltage dividing component 220 can be reduced so as to more easily be measured or processed. The first and second resistors may also have parasitic capacitance engaging in the voltage dividing.

The first diode D1 is coupled in parallel with the series-coupled first voltage dividing components 210, and the second diode D2 is coupled in parallel with the second voltage dividing component 220. The first diode D1 has a voltage rating equal to or larger than a voltage rating of the second diode D2. The first diode D1 is configured to discharge the second capacitor C2, during the switching on period of the switch device. During the switch off period of the switch device, the second capacitor C2 may be charged. Then when the switch device is switched on, the second capacitor C2 will be discharged through the first diode D1 and switch device 910. In some embodiments, each of the first and second diodes may be replaced with a plurality of diodes.

The signal processor 230 comprises a judging unit configured to judge whether the divided voltage is equal to or larger than a reference voltage. The reference voltage indicates an operating voltage of the switch device. In some embodiments, the reference voltage can be set as a fraction of the operating voltage of the switch device, and the fraction may be a ratio of a resistance of the second resistor to a total resistance of the first and second resistors.

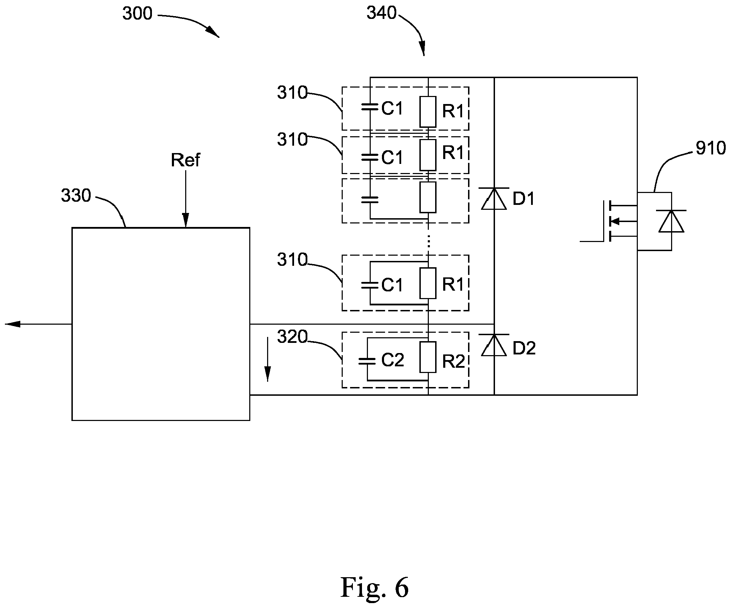

Fig. 6 shows a sketch view of a detecting circuit 300 in accordance with another exemplary embodiment of the present disclosure. Referring to Fig. 6, the detecting circuit 300 comprises a voltage divider 340, a signal processor 330, a first diode and a second diode D1, D2.

The voltage divider 340 is coupled in parallel with the corresponding switch device 910 and comprises a plurality of voltage dividing components 310, 320 in series connection. The plurality of voltage dividing components comprises a plurality of first voltage dividing components 310 and a second voltage dividing component 320. The plurality of first voltage dividing components 310 are in series connection. The second voltage dividing component 320 is coupled with the signal processor 330 and configured to provide a divided voltage across the second voltage dividing component 320 to the signal processor 330.

In the embodiment shown in Fig. 6, each of the first voltage dividing components comprises a first resistor R1 and a first capacitor C1 coupled in parallel with the first resistor R1. The second voltage dividing component comprises a second resistor R2 and a second capacitor C2 coupled in parallel with the second resistor R2. The first resistor R1 has a resistance larger than the resistor R2, and the first capacitor C1 has a capacitance less than the capacitor C2, in such a manner that more voltage will be distributed to the first voltage dividing components 310, and thus the divided voltage across the second voltage dividing component 320 can be reduced and more easily be measured or processed.

The first diode D1 is coupled in parallel with the series-coupled first voltage dividing components, and the second diode D2 is coupled in parallel with the second voltage dividing component. The first diode D1 has a voltage rating equal to or larger than a voltage rating of the second diode D2, since the voltage across the first voltage dividing components 310 is larger than the voltage across the second voltage dividing component 320. The first and second diodes are configured to discharge the first and second capacitor C1, C2, during the switching on period of switch device 910. In some embodiments, each of the first and second diodes may be replaced with a plurality of diodes.

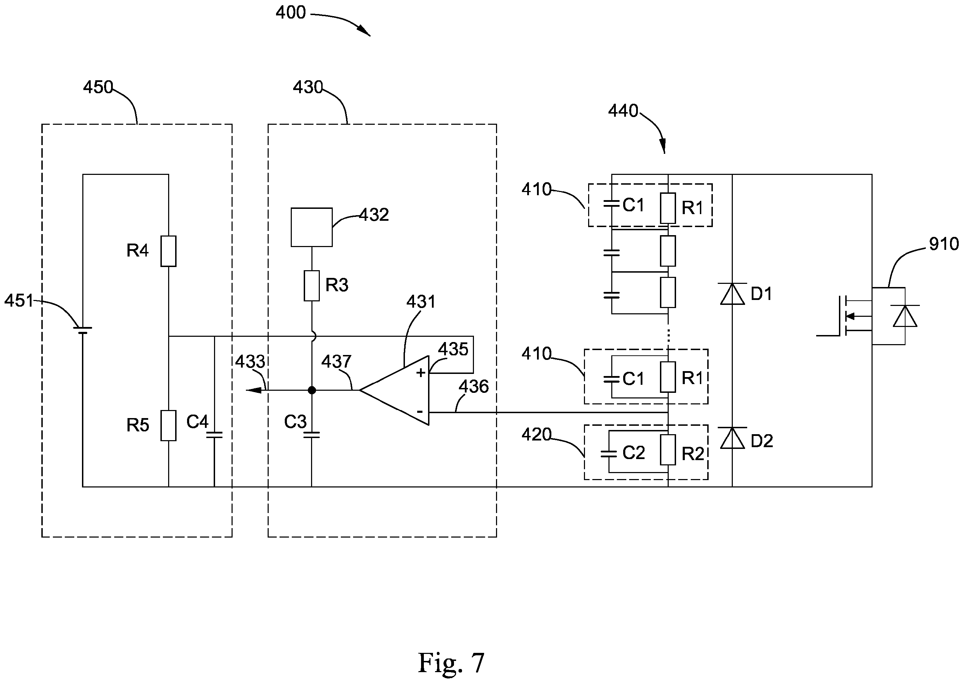

Fig. 7 shows a sketch view of a detecting circuit 400 in accordance with an exemplary embodiment of the present disclosure. Referring to Fig. 7, the detecting circuit 400 comprises a voltage divider 440, a signal processor 430, a first diode D1, a second diode D2 and a reference voltage source 450.

The voltage divider 440, the first diode D1 and the second diode D2 may be similar to the corresponding components of the detecting circuit 300 shown in Fig. 6, description of which will not be repeated here.

The signal processor 430 comprises a comparing circuit, which is configured to compare the divided voltage with a reference voltage, and output a signal indicating whether the divided voltage is equal to or larger than the reference voltage. In some embodiments, the comparing circuit 430 outputs a low level signal to indicate that the divided voltage is equal to or larger than the reference voltage, or a high level signal to indicate that the divided voltage is less than the reference voltage.

As shown in Fig. 7, the comparing circuit 430 comprises a comparator 431, a third resistor R3, a third capacitor C3 and an auxiliary power source 432. The comparator 431 comprises a first input terminal 435, a second input terminal 436 and an output terminal 437. The first input terminal 435 is coupled with the reference voltage source 450 and configured to receive the reference voltage. The second input terminal 436 is coupled with a first terminal of the second voltage dividing component 420 and configured to receive the divided voltage, wherein the first terminal of the second voltage dividing component 420 has an electric potential higher than a second terminal of the second voltage dividing component 420 when the switch device is in a switch off state.

The third resistor R3 is coupled between the auxiliary power source 432 and the output terminal 437 of the comparator 431. The third capacitor C3 is coupled between the output terminal 437 of the comparator 431 and the second terminal of the second voltage dividing component 420, and configured to stabilize the signal from the output terminal 437 of the comparator 431.

The reference voltage source 450 is coupled with the first input terminal 435 of the comparator 431 and configured to provide the reference voltage to the comparator 431. The reference voltage source 450 comprises a direct voltage source 451, a fourth resistor R4, a fifth resistor R5 and a fourth capacitor C4. The fourth and fifth resistors R4, R5 are coupled in series between an anode and a cathode of the direct voltage source 451, wherein the cathode of the direct voltage source 451 is coupled with the second terminal of the second voltage dividing component 420. The fourth capacitor C4 is coupled in parallel with the fifth resistor R5. The first input terminal 435 of the comparator 431 is coupled with a node between the fourth resistor R4 and the fifth resistor R5, so that a voltage across the fifth resistor R5 is provided to the comparator 431 as the reference voltage.

Embodiments of the present disclosure relate to a method for protecting a circuit comprising a plurality of switch devices coupled in series.

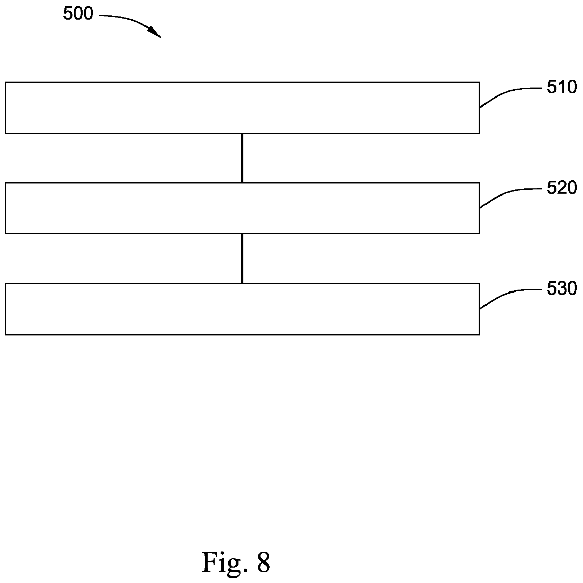

Fig. 8 is a flowchart illustrating a method 500 for protecting a circuit comprising a plurality of switch devices coupled in series. Referring to Fig. 8, the method 500 comprises step 510 to step 530.

In step 510, a voltage across each switch device is detected by a detecting device. The detecting device comprises a plurality of detecting circuits configured to detect voltage information associated with the plurality of switch devices respectively, wherein each detecting circuit is integrated with a gate driver of the corresponding switch device. Each detecting circuit comprises a voltage divider coupled in parallel with the corresponding switch device and comprising a plurality of voltage dividing components coupled in series. Each detecting circuit further comprises a signal processor, coupled with one of the voltage dividing components, and configured to receive a divided voltage across the voltage dividing component and output an output signal indicating the voltage across the switch device.

In step 520, each switch device is determined whether to have a failure risk based on the voltage across each switch.

Step 530 relates to making each of the switch device(s) having the failure risk in a constant on-state to reduce or eliminate the failure.

As will be understood by those familiar with the art, the present disclosure may be embodied in other specific forms without depending from the spirit or essential characteristics thereof. Accordingly, the disclosures and descriptions herein are intended to be illustrative, but not limiting, of the scope of the disclosure which is set forth in the following claims.

## Claims

1. A detection device for a circuit comprising a plurality of switch devices coupled in series, the detection device comprising:
a plurality of detecting circuits, wherein each detecting circuit is integrated with a gate driver of a corresponding switch device, and each detecting circuit comprises:
a voltage divider, coupled in parallel with the corresponding switch device and comprising a plurality of voltage dividing components coupled in series, and
a signal processor, coupled with one of the voltage dividing components, and configured to receive a divided voltage across the voltage dividing component and output an output signal indicating the voltage across the switch device.

2. The detection device according to claim 1, wherein the detecting circuit and the gate driver are provided on a substrate to form a printed circuit board, and the printed circuit board is adjacent to the switch device.

3. The detection device according to claim 1, wherein the plurality of voltage dividing components comprises:
a plurality of first voltage dividing components, each comprising a first resistor; and
a second voltage dividing component coupled with the signal processor, the second voltage dividing component comprising a second resistor;
wherein the first resistor has a resistance larger than the second resistor.

4. The detection device according to claim 3, wherein the second voltage dividing component further comprises a capacitor coupled in parallel with the second resistor.

5. The detection device according to claim 4, wherein the detecting circuit further comprises:
a first diode coupled in parallel with the series-coupled first voltage dividing components; and
a second diode coupled in parallel with the second voltage dividing component;
wherein the first diode has a voltage rating equal to or larger than a voltage rating of the second diode.

6. The detection device according to claim 3, wherein each of the first voltage dividing components further comprises a first capacitor coupled in parallel with the first resistor, the second voltage dividing component further comprises a second capacitor coupled in parallel with the second resistor, and the first capacitor has a capacitance less than the second capacitor.

7. The detection device according to claim 6, wherein the detecting circuit further comprises:
a first diode coupled in parallel with the series-coupled first voltage dividing components; and
a second diode coupled in parallel with the second voltage dividing component,
wherein the first diode has a voltage rating equal to or larger than a voltage rating of the second diode.

8. The detection device according to claim 1, wherein the signal processor comprises a measuring device configured to measure the divided voltage.

9. The detection device according to claim 1, wherein the signal processor comprises a judging unit configured to judge whether the divided voltage is equal to or larger than a reference voltage.

10. The detection device according to claim 9, wherein the reference voltage indicates an operating voltage of the switch device.

11. The detection device according to claim 9, wherein the judging unit comprises a comparator configured to compare the divided voltage with the reference voltage.

12. The detection device according to claim 1, wherein the switch device comprises at least one of a silicon carbide insulated gate bipolar transistor and a silicon carbide metal-oxide-semiconductor field effect transistor.

13. A protection system for protecting a circuit comprising a plurality of switch devices coupled in series, the system comprising:
a detection device comprising a plurality of detecting circuits, wherein each detecting circuit is integrated with a gate driver of a corresponding switch device and comprises:
a voltage divider, coupled in parallel with the corresponding switch device and comprising a plurality of voltage dividing components coupled in series, and
a signal processor, coupled with one of the voltage dividing components, and configured to receive a divided voltage across the voltage dividing component and output an output signal indicating the voltage across the switch device; and
a control device configured to determine whether each switch device has a failure risk based on the output signal, and make the switch device(s) having the failure risk in a constant on-state to reduce the failure risk.

14. A method for protecting a circuit comprising a plurality of switch devices coupled in series, the method comprising:
detecting a voltage across each switch device by a detecting device;
determining whether each switch device has a failure risk based on the voltage; and
making each of the switch device(s) having the failure risk in a constant on-state to reduce the failure risk;
wherein the detecting device comprises a plurality of detecting circuits, each detecting circuit is integrated with a gate driver of a corresponding switch device and comprises:
a voltage divider, coupled in parallel with the corresponding switch device and comprising a plurality of voltage dividing components coupled in series, and
a signal processor, coupled with one of the voltage dividing components, and configured to receive a divided voltage across the voltage dividing component and output an output signal indicating the voltage across the switch device.
